# FASCICULE DE BREVET EUROPEEN

(11) **EP 3 023 881 B1**
(45) Date de publication et mention de la délivrance du brevet: **20.12.2017**
(21) Numéro de dépôt: 15194335.4
(22) Date de dépôt: 12.11.2015
(51) Int. Cl.: G06F 13/40, H05K 7/14, H01H 89/00

(54) **SYSTEME COMPRENANT UNE EMBASE ET UN MODULE DE CONNEXION A CETTE EMBASE AVEC DES MOYENS DE CODAGE D'UNE ADRESSE DANS L'EMBASE ET DES MOYENS DE LECTURE PAR LE MODULE DE L'ADRESSE CODEE**
SYSTEM MIT SOCKEL UND EINEM ANSCHLUSSMODUL AN DIESEN SOCKEL MIT KODIERMITTELN EINER ADRESSE IM SOCKEL UND LESEMITTELN FÜR DAS MODUL DER KODIERTEN ADRESSE
SYSTEM COMPRISING A BASE AND A MODULE FOR CONNECTING TO SAID BASE, WITH MEANS FOR ENCODING AN ADDRESS IN THE BASE AND MEANS FOR READING THE ENCODED ADDRESS BY THE MODULE

(30) Priorité: 19.11.2014 FR 1461196
(43) Date de publication de la demande: 25.05.2016
(73) Titulaire: Schneider Electric Industries SAS, 92500 Rueil-Malmaison (FR)
(72) Inventeur: MARMONIER, Jean, 38050 GRENOBLE CEDEX 9 (FR); GUENEGO, Michel, 38050 GRENOBLE CEDEX 9 (FR); VAN DER MEE, Marnix, 38050 GRENOBLE CEDEX 9 (FR)
(74) Mandataire: Brevalex

(56) Documents cités:
- EP-A1- 0 362 985
- FR-A1- 2 893 742
- US-A- 4 701 878

## Description

### DOMAINE TECHNIQUE

L'invention concerne un système comprenant un module d'acquisition d'information ou d'émission d'ordres de commande destiné à être connecté par un câble à une unité électronique intelligente, et une embase destinée à recevoir ce module pour connecter cette embase à l'unité électronique intelligente.

### ÉTAT DE LA TECHNIQUE ANTÉRIEURE

L'invention concerne une installation comprenant d'une part une unité de gestion, encore appelée unité électronique intelligente, et d'autre part des équipements qui sont reliés à cette unité de gestion. Dans une telle installation, l'unité de gestion communique avec ces équipements pour échanger des signaux afin de les piloter pour exécuter par exemple un processus industriel.

La connexion d'une telle installation implique généralement de se conformer à une configuration prédéterminée définissant en particulier pour chaque embase le port de l'unité de gestion à laquelle elle doit être raccordée. Ce raccordement est assuré par un module qui s'engage dans l'embase et qui comporte un câble de raccordement à un port de l'unité de gestion.

En cas d'erreur de raccordement, il est alors nécessaire soit de reprendre le raccordement pour le rendre conforme à la configuration prévue, soit d'agir sur l'unité de gestion pour qu'elle prenne en compte les connexions effectivement en place.

Quoi qu'il en soit, cette configuration aboutit à un système figé dans lequel on doit prévoir des moyens pour interdire toute interversion de modules ou de ports lors par exemple d'une opération de maintenance. En effet, une interversion de deux modules ou de deux câbles non identifiée dans l'unité électronique de gestion conduirait à des interversions dans les transmissions de données, et par là même à des dysfonctionnements de l'installation.

Cette solution nécessite ainsi une grande rigueur en matière de raccordement, ce qui se traduit par un coût élevé résultant notamment de la nécessité d'apposer des repères et autres élément de détrompage sur les modules, sur les embases et sur les ports de l'unité de gestion.

Dans les documents de brevet EP0592923 et EP0362985, il est prévu de recourir à un système mécanique de codage. Dans le cas du document EP0592923, ce système mécanique assure en outre une fonction de détrompage, avec lequel chaque paire comprenant un module et son embase associée reçoit une même combinaison mécanique. L'agencement assure qu'une embase ayant un codage mécanique donné ne peut recevoir un module que s'il a été configuré avec le même codage mécanique, sans quoi l'emboîtement n'est pas possible.

En cas de changement d'un module, l'opérateur doit néanmoins recopier dans le nouveau module le code de l'ancien module, ce qui peut correspondre à une opération complexe. Par ailleurs, on ne peut pas exclure qu'en cas de mauvaise combinaison mécanique, l'opérateur tente malgré tout d'emboîter le module dans l'embase en force, en le détériorant, de sorte qu'un codage mécanique n'est pas totalement approprié.

### EXPOSÉ DE L'INVENTION

L'invention a pour objet un système tel que défini dans la revendication indépendante 1. L'invention apporte à la fois une grande facilité d'utilisation et une grande robustesse dans l'identification des adresses du système qui se fait de manière entièrement automatique dès lors que les différentes embases ont été configurées avec leurs adresses respectives. D'autres modes de réalisation de l'invention sont spécifiés dans les revendications dépendantes attenantes.

### BRÈVE DESCRIPTION DES DESSINS

- la figure 1 est une vue en perspective d'une embase du système selon l'invention ;
- la figure 2 est une vue en coupe d'un module du système selon l'invention ;
- la figure 3 est une vue en coupe d'une embase du système selon l'invention ;
- la figure 4 est une vue en perspective d'un système de codage magnétique équipant une embase selon l'invention ;
- la figure 5 est une vue partielle d'un élément de codage magnétique selon l'invention dans une première configuration avec son volet rabattu ;
- la figure 6 est une vue partielle d'un élément de codage magnétique selon l'invention dans une seconde configuration avec son volet rabattu ;
- la figure 7 est une vue en perspective d'un curseur d'élément de codage magnétique selon l'invention représenté seul ;
- la figure 8 est une vue partielle d'un élément de codage magnétique selon l'invention dans une première configuration lorsque son volet est ouvert ;
- la figure 9 est une vue partielle d'un élément de codage magnétique selon l'invention dans une configuration intermédiaire lorsque son volet est ouvert ;
- la figure 10 est une vue partielle d'un élément de codage magnétique selon l'invention dans une configuration intermédiaire rendant impossible le rabattage de son volet ;
- la figure 11 est une vue d'un système de codage selon l'invention lorsque son volet est partiellement rabattu du fait qu'un de ses éléments de codage magnétique est dans une position intermédiaire ;
- la figure 12 est une vue en coupe montrant l'embase avec son volet ouvert qui empêche l'entrée du module dans cette embase ;
- la figure 13 est une vue en coupe montrant l'embase avec son volet qui empêche l'entrée du module du fait que son rabattement complet est rendu impossible par le mauvais positionnement d'un élément de codage magnétique ;
- la figure 14 est une vue en coupe montrant l'embase avec son volet entièrement rabattu qui permet l'engagement complet du module.

### EXPOSÉ DÉTAILLÉ DE MODES DE RÉALISATION PARTICULIERS

L'idée à la base de l'invention est d'équiper chaque embase de moyens de codage à aimants permanents pour coder sur chaque embase son adresse avec ces moyens, et d'équiper chaque module de capteurs magnétiques correspondants. Chaque module est ainsi en mesure de lire l'adresse codée dans l'embase qui le reçoit pour transmettre cette adresse à l'unité de gestion à laquelle il est connecté.

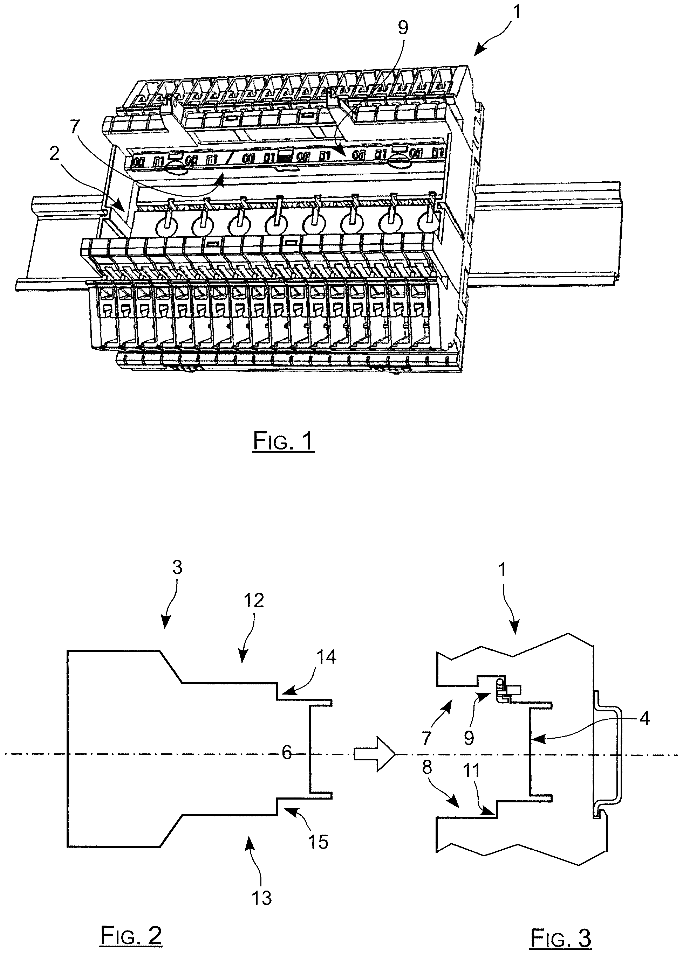

L'embase du système selon l'invention qui est représentée dans la figure 1 en y étant repérée par 1 comporte une cavité centrale 2 destinée à recevoir un module 3 visible en figure 2, ce module étant connecté à une unité électronique intelligente par un câble, de manière à connecter ce module 3 à l'embase 1 pour relier cette embase à l'unité électronique intelligente.

La cavité centrale 2 comporte un fond 4 sur lequel vient en appui une extrémité de connexion 6 du module 3 lorsqu'il est emboîté dans l'embase, la connexion électrique étant assurée au niveau de l'extrémité 6 et du fond 4 lorsqu'ils sont réunis.

Cette cavité 2 présente une embouchure plus large que son fond 4 en étant délimitée latéralement par deux flancs 7 et 8 comportant chacun, à mi-profondeur de la cavité, un décrochement latéral, ces décrochements étant repérés 9 et 11.

Le module 3 comporte un corps de forme complémentaire à cette cavité, ce corps ayant une forme qui s'évase depuis son extrémité libre 6 en étant délimitée par deux flancs latéraux 12 et 13 comportant chacun un décrochement, ces décrochements étant repérés par 14 et 15, respectivement.

Lorsque le module 1 est en place dans l'embase, son extrémité 6 est en appui sur le fond 4, et les décrochements 14 et 15 du module sont en vis-à-vis des décrochements 9 et 11 de l'embase, respectivement.

Les décrochements 9 et 11 de l'embase, ainsi que les décrochements 14 et 15 du module constituent des marches délimitant chacun une surface d'orientation normale à la direction d'engagement du module dans l'embase, c'est-à-dire parallèle au fond 4 de l'embase ou à l'extrémité 6 du module en place dans l'embase.

L'un au moins des décrochements de l'embase, ici le décrochement 9, est équipé d'un système de codage à aimants permanents permettant de coder plusieurs composantes binaires afin de coder magnétiquement un mot binaire correspondant à l'adresse de cette embase. Ce système comporte pour chaque composante binaire à coder un aimant permanent pouvant occuper une position parmi deux possibles afin de donner soit la valeur 0 soit la valeur 1 à la composante binaire qu'il représente. Ces aimants sont situés dans le corps d'embase, en vis-à-vis du décrochement 9.

Complémentairement, le module 3 est pourvu au niveau de son décrochement 14 d'une série de capteurs magnétiques, tels que des capteurs à effet Hall. Le module 3 est ainsi en mesure d'identifier avec ses capteurs la position de chaque aimant de l'embase dans laquelle il est emboîté, pour identifier le mot binaire correspondant à l'adresse de cette embase.

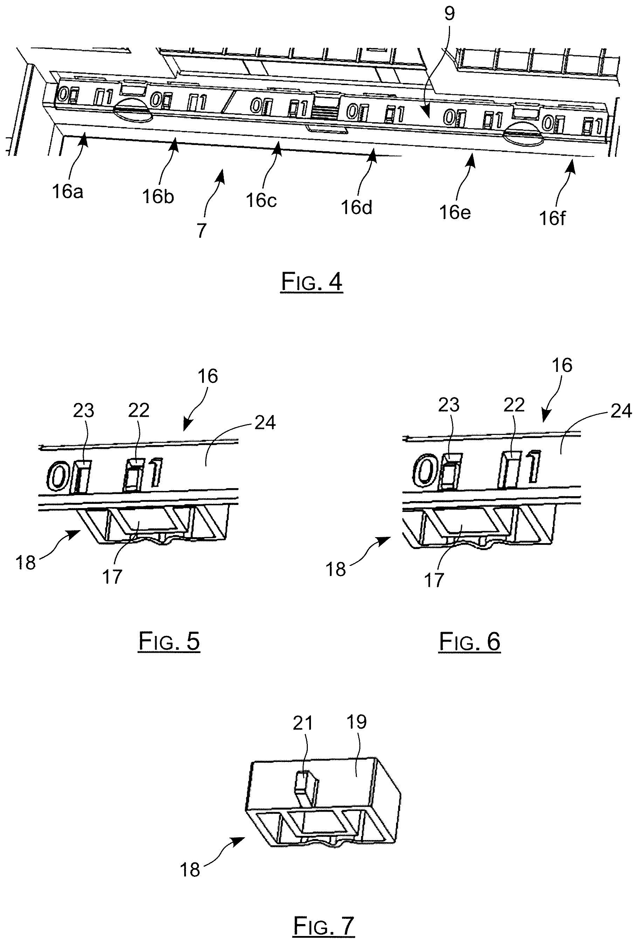

L'épaulement 9 de l'embase 1 qui apparaît seul dans la figure 4 comporte six éléments de codage magnétique, repérés par 16a, 16b, 16c, 16d, 16e, 16f, permettant chacun de coder une composante binaire, pour définir ensemble un mot binaire à six composantes. Dans l'exemple de la figure 4, les éléments 16a et 16b sont à la valeur 0, et les éléments 16c à 16f sont à la valeur 1, ce qui correspond au mot binaire 001111.

Comme illustré sur les figures 5 à 7, chaque élément 16 comporte un aimant permanent 17 emboîté dans un curseur 18 qui peut être placé dans l'une ou l'autre de deux positions espacées l'une de l'autre le long du décrochement 9.

Dans la configuration de la figure 5, le curseur est placé et immobilisé à sa première position, qui correspond par convention à la valeur 1, alors que dans la situation de la figure 6, ce curseur est placé et immobilisé à sa seconde position qui correspond par convention à la valeur 0. Concrètement, lorsque le curseur est à sa première position comme dans la figure 5, il est en vis-à-vis du capteur à effet Hall correspondant du module pour être détecté par celui-ci, alors que lorsqu'il occupe sa seconde position comme dans la figure 6, il est décalé par rapport au capteur pour ne pas être détecté par celui-ci.

Le curseur qui apparaît seul dans la figure 7 comporte une face 19 orientée vers le décochement 9, dont la partie centrale porte un ergot 21 apte à s'engager dans l'une ou l'autre de deux ouvertures 22, 23 qui correspondent à la première ou à la deuxième position pouvant être occupées par ce curseur.

Ces deux ouvertures 22 et 23 sont en fait portées par un volet mobile 24, rabattable, qui ne peut ainsi être rabattu que si le curseur 18 occupe précisément sa première ou sa seconde position, de manière à interdire tout positionnement imprécis de ce curseur par un opérateur.

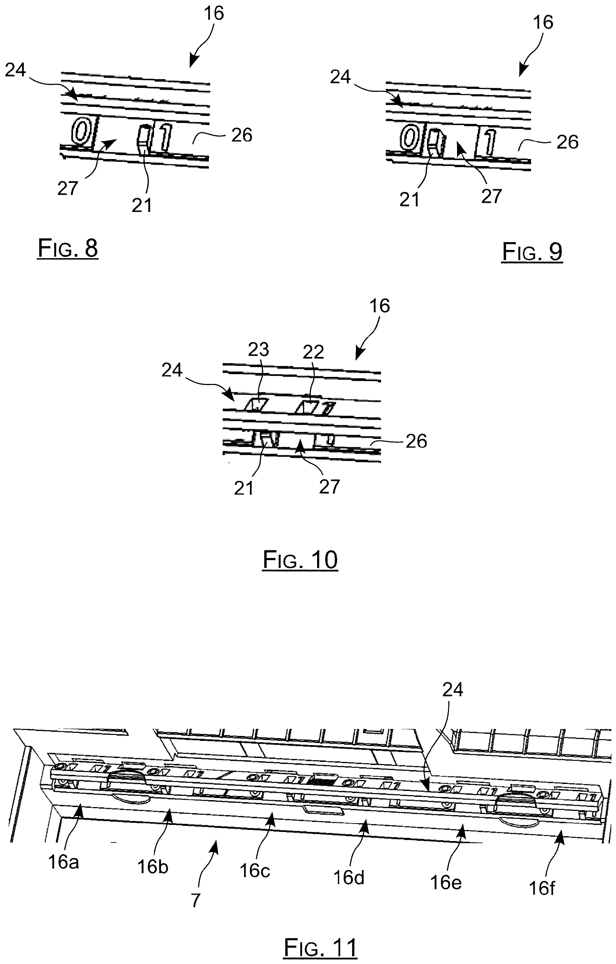

Plus particulièrement, et comme visible notamment sur les figures 8 à 10, le décrochement 9 est délimité par une paroi fixe 26 et par le volet mobile 24 qui se rabat sur cette paroi fixe.

Au niveau de chaque élément de codage, la paroi fixe 26 comporte une fenêtre ou ouverture 27 recevant l'ergot 21 du curseur correspondant, cet ergot 21 étant situé contre l'un des bords de la fenêtre 27 si le curseur occupe sa première position, et contre le bord opposé si le curseur occupe la seconde position.

Dans l'exemple de la figure 8, le curseur est placé précisément à la première position, contre le bord correspondant de l'ouverture 27, de sorte que lorsque le volet 24 est rabattu, l'ergot 21 est situé au droit de l'ouverture 22 pour s'engager dans celle-ci afin de permettre le rabattage du volet, ce qui correspond à la situation de la figure 5.

Dans le cas où l'opérateur configurant l'embase positionnerait de manière imprécise le curseur, comme dans la figure 9 où ce curseur occupe une position intermédiaire entre la première position et la seconde position, le volet 24 ne peut alors pas être entièrement rabattu contre la paroi 26.

Dans ce cas qui correspond aussi à la situation de la figure 10, lorsqu'on tente de rabattre le volet 24, l'ergot 21 du curseur étant dans une position intermédiaire, il ne tombe ni en face de l'ouverture 22 du volet, ni en face de l'ouverture 23, de sorte qu'il ne peut s'engager dans aucune des deux. Ceci empêche le rabattage complet de ce volet 24.

Dans ces conditions, l'opérateur réalise alors qu'il existe un défaut de configuration, qu'il corrige en replaçant le curseur correctement pour permettre le rabattage complet du volet 24.

Comme illustré sur la figure 11, le volet 24 s'étend sur toute la longueur du décrochement 9 pour couvrir tous les éléments de codage magnétique lorsqu'il est rabattu. Ainsi, dès lors que l'un des éléments de codage est incorrectement positionné, cela empêche la fermeture de l'ensemble du volet afin d'inciter l'opérateur à corriger son erreur.

Le volet 24 comporte un rebord assurant que lorsque ce volet est complètement ouvert, son rebord dépasse vers l'intérieur de la cavité 2 pour constituer une protubérance qui empêche la progression du module 3 dans l'embase pour rendre sa connexion impossible.

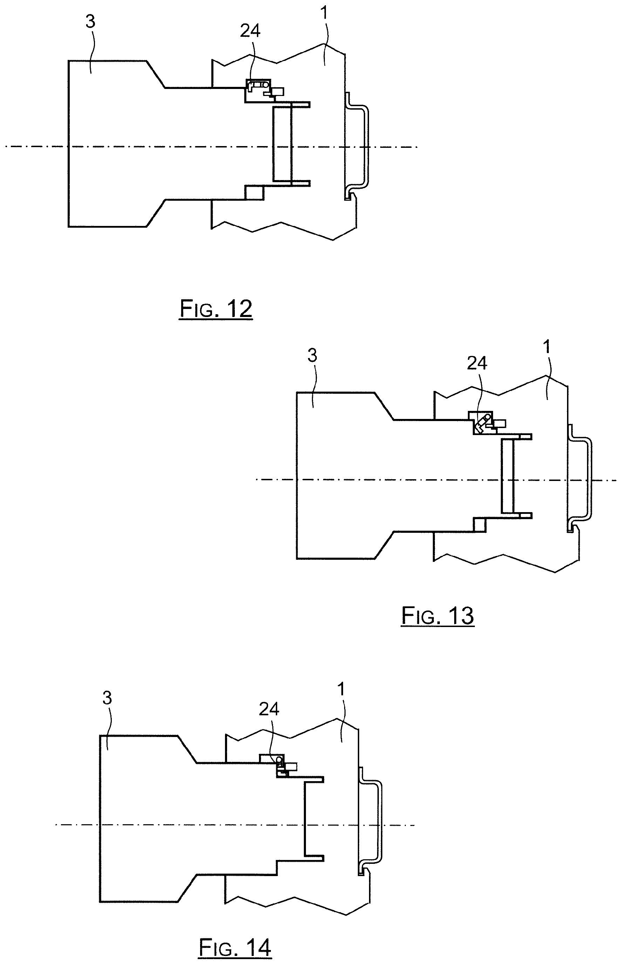

Tant que le volet 24 n'est pas entièrement rabattu contre la paroi fixe du décrochement 9, il dépasse vers l'intérieur de la cavité pour interdire la progression du module dans l'embase. C'est par exemple le cas dans la situation de la figure 12, où le volet 24 est ouvert de sorte que son rebord dépasse vers l'intérieur de la cavité pour interdire l'emboîtement du module dans l'embase, et par là même leur connexion mutuelle. Il en va de même lorsque le volet ne peut être entièrement rabattu contre la paroi fixe 26 du fait d'un curseur mal positionné, comme dans la figure 13, de sorte que ce volet dépasse alors du décrochement 9 pour empêcher l'engagement du module.

Au contraire, lorsque les différents curseurs sont correctement positionnés, le volet 24 peut être entièrement rabattu contre la paroi fixe du décrochement, comme dans la situation de la figure 13, de sorte que ce volet ne dépasse plus vers la cavité afin de permettre l'engagement complet du module dans l'embase de manière à permettre sa connexion.

Le volet 24 permet ainsi de bloquer en position les différents curseurs, grâce aux ouvertures qu'il comporte et dans lesquelles s'engagent les ergots, et il rend impossible la mise en service d'un module dans une embase dont un des curseurs serait mal positionné.

En pratique, la configuration de l'embase est assurée par l'opérateur lorsqu'il installe l'embase dans une armoire ou un coffret électrique. Lorsqu'il a terminé de configurer les différents curseurs de l'embase et qu'il a rabattu le volet, il peut apposer une étiquette sur le volet et le reste du flanc de la cavité pour interdire désormais l'ouverture de ce volet. Cette étiquette forme alors un scellé interdisant une modification de l'adresse de cette embase sans destruction de l'étiquette.

Complémentairement au système de codage magnétique qui équipe l'embase, chaque module est équipé d'une série de capteurs à effet Hall disposés au niveau de son décrochement 14, de manière à être en vis-à-vis du système de codage de l'embase lorsque le module est en place.

Chaque capteur à effet Hall équipant le module est associé à un élément de codage de l'embase en étant monté dans le module au niveau de son décrochement 14 de manière à être au voisinage de l'élément correspondant lorsque le module est en place dans l'embase. Plus particulièrement le capteur à effet Hall du module qui est associé à un élément magnétique de l'embase est positionné dans le long du décrochement 14 du module de façon à être en vis-à-vis de l'aimant lorsque le curseur portant cet aimant occupe la première position correspondant à la valeur 1.

Ainsi, lorsque le module est engagé dans l'embase, la lecture de l'adresse consiste à interroger chaque capteur à effet Hall pour déterminer s'il détecte ou non un aimant. Lorsqu'un aimant est détecté, cela signifie que l'élément de codage correspondant est à la valeur 1, et lorsque le capteur à effet Hall ne détecte pas d'aimant, cela signifie que l'élément de codage magnétique est au contraire à la valeur 0.

Dans l'exemple des figures, l'embase comporte six éléments de codage magnétique, de sorte que le module est équipé de six capteurs à effet Hall correspondants. L'adresse de l'embase peut ainsi être codée sous la forme d'un mot booléen à six composantes, et cette adresse peut être lue par le module en place dans l'embase pour être transmise à l'unité à laquelle ce module est relié.

Complémentairement, le module est équipé d'une unité de pilotage de ses capteurs et de moyens de mémorisation, tels qu'une carte à microcontrôleur et comportant des éléments de mémoire volatile. Lorsque le module est mis sous tension, il est programmé au niveau de cette carte pour effectuer une lecture d'adresse via ses capteurs à effet Hall, par exemple durant la demi-seconde qui suit la mise sous tension.

La lecture d'adresse est ainsi réalisée ponctuellement, pendant une faible durée, au lieu de l'être périodiquement, pour limiter les risques de perturbation de cette lecture, par exemple par un aimant externe qui serait déplacé au voisinage du système en cours de fonctionnement.

Si une adresse est effectivement lue via ces capteurs à effet Hall, alors elle est mémorisée dans le module au niveau de sa carte pendant tout le temps qu'il est maintenu sous tension, et elle est transmise avec chaque communication du module vers l'unité électronique intelligente à laquelle il est relié. Du côté de l'unité électronique intelligente, la cohérence de l'adresse est avantageusement vérifiée de façon à apporter une sécurité supplémentaire.

Ainsi, une fois que le module a été connecté et mis sous tension, il a transmis à l'unité électronique intelligente l'adresse de l'embase à laquelle il est connecté. Cette unité électronique intelligente peut alors envoyer à cette embase identifiée, via le module en question, les ordres, instructions ou signaux appropriés pour l'embase en question ou pour l'équipement que cette embase pilote. Le cas échéant, les caractéristiques propres à l'embase ou à l'équipement qu'elle pilote sont identifiées par l'unité électronique intelligente au moyen d'une base de données qu'elle interroge avec l'adresse de l'embase.

Dans l'exemple illustré sur les figures, le système de codage d'adresse de l'embase 1 est magnétique et les moyens de lecture du module sont des capteurs magnétiques, mais d'autres solutions peuvent être mises en oeuvre pour ce codage.

En particulier, le système de codage peut être un système mécanique comportant par exemple des picots ou des languettes configurables pour coder une adresse. Les moyens de lecture du module peuvent alors se présenter sous forme de capteurs mécaniques de type interrupteurs sensibles à la présence ou à l'absence d'une protubérance de type picot ou languette lorsque le module est en place dans l'embase.

Grâce à l'invention, l'opérateur ne doit réaliser aucune programmation durant le remplacement d'un module : ce remplacement consiste à retirer le module, à le déconnecter de l'unité électronique intelligente, et à insérer le nouveau module dans l'embase et à le connecter à l'unité.

Par ailleurs, le câble par lequel un module est connecté à un port de l'unité électronique intelligente peut de manière analogue être déconnecté de ce port pour être reconnecté à un autre port de cette unité électronique intelligente. Lors de la reconnexion, l'adresse de l'embase va à nouveau être transférée à l'unité intelligente, mais par le nouveau port, ce qui va suffire à l'unité intelligente pour identifier sa connexion avec l'embase.

Il n'est ainsi pas non plus nécessaire que chaque module soit spécifiquement associé à un port prédéfini de l'unité électronique intelligente, de sorte qu'une éventuelle erreur en ce qui concerne le port de raccordement d'un module n'a en réalité aucune incidence sur le fonctionnement du système.

## Revendications

1. Système comprenant une embase (1) et un module (3) s'emboîtant dans cette embase (1) pour s'y connecter électriquement afin de transférer des informations, l'embase étant reliée à un équipement et le module (3) étant relié à une unité de gestion de cet équipement, **caractérisé en ce que** l'embase (1) est équipée d'un système de codage (16a-16f) d'adresse magnétique à aimants permanents (17) comportant plusieurs éléments de codage (16) incluant chacun un curseur (18) portant un aimant permanent (17) en étant mobile en translation entre une première position de codage (22) et une deuxième position de codage (23), et **en ce que** le module (3) comporte des moyens de lecture de l'adresse codée dans le système de codage de l'embase (1), ces moyens de lecture comportant une série de capteurs magnétiques situés chacun en vis-à-vis d'un élément de codage magnétique (16) lorsque le module (3) est en place dans l'embase (1), ainsi que des moyens de mémorisation de l'adresse lue par les moyens de lecture tant que ce module (3) est sous tension et des moyens de transmission de l'adresse mémorisée à l'unité de gestion..

2. Système selon la revendication 1, dans lequel chaque curseur (18) compote un ergot (21), et dans lequel l'embase (1) est équipée d'un volet mobile (24) qui est rabattable vers les éléments de codage (16), ce volet rabattable (24) comportant pour chaque élément de codage (16) deux ouvertures (22, 23) de passage de l'ergot (21) du curseur (18) de cet élément de codage (16), pour permettre le rabattement du volet (24) lorsque chaque curseur (18) occupe sa première position ou sa seconde position.

3. Système selon la revendication 2, dans lequel le volet (24) est agencé pour empêcher l'engagement complet du module (3) dans l'embase ainsi que sa connexion tant que ce volet mobile (24) n'est pas complètement rabattu contre les éléments de codage (16).

4. Système selon l'une des revendications précédentes, dans lequel le module (3) s'engage dans une cavité (2) de l'embase (1) qui est délimitée par au moins un flanc (7) comportant un décrochement (9) en forme de marche rendant la cavité (2) plus étroite au niveau de son fond (4) qu'au niveau de son embouchure, et dans lequel le système de codage est intégré à ce décrochement (9).

## Patentansprüche

1. System, enthaltend einen Sockel (1) und ein Modul (3), das in diesen Sockel (1) eingreift, um sich elektrisch damit zu verbinden, um Informationen zu übermitteln, wobei der Sockel mit einer Einrichtung verbunden ist und das Modul (3) mit einer Steuereinheit zum Steuern dieser Einrichtung verbunden ist,
**dadurch gekennzeichnet, dass** der Sockel (1) mit einem magnetischen Adresscodierungssystem (16a - 16f) mit Permanentmagneten (17) versehen ist, das mehrere Codierungselemente (16) enthält, die jeweils einen Schieber (18) umfassen, der einen Permanentmagneten (17) trägt und dabei zwischen einer ersten Codierungsposition (22) und einer zweiten Codierungsposition (23) translatorisch verschiebbar ist, und
dass das Modul (3) Einlesemittel zum Einlesen der codierten Adresse in das Codierungssystem des Sockels (1) aufweist, wobei diese Einlesemittel eine Reihe von Magnetsensoren aufweisen, die jeweils einem magnetischen Codierungselement (16) gegenüberliegen, wenn das Modul (3) in dem Sockel (1) in Stellung ist, sowie Speichermittel zum Abspeichern der von den Einlesemitteln eingelesenen Adresse, solange dieses Modul (3) unter Spannung ist, und Übertragungsmittel zum Übertragen der abgespeicherten Adresse an die Steuereinheit.

2. System nach Anspruch 1, wobei jeder Schieber (18) einen Vorsprung (21) aufweist und wobei der Sockel (1) mit einer beweglichen Klappe (24) versehen ist, die zu den Codierungselementen (16) hin umklappbar ist, wobei diese umklappbare Klappe (24) für jedes Codierungselement (16) zwei Öffnungen (22, 23) zum Durchtritt des Vorsprungs (21) des Schiebers (18) dieses Codierungselements (16) aufweist, um das Umklappen der Klappe (24) dann zu gestatten, wenn jeder Schieber (18) seine erste Position bzw. seine zweite Position einnimmt.

3. System nach Anspruch 2, **dadurch gekennzeichnet, dass** die Klappe (24) dazu vorgesehen ist, das vollständige Eingreifen des Moduls (3) in den Sockel sowie seine Verbindung zu verhindern, solange diese bewegliche Klappe (24) nicht vollständig auf die Codierungselemente (16) umgeklappt ist.

4. System nach einem der vorangehenden Ansprüche, wobei das Modul (3) in einen Hohlraum (2) des Sockels (1) eingreift, der von zumindest einer Flanke (7) mit einem stufenförmigen Absatz (9) begrenzt ist, der den Hohlraum (2) im Bereich seines Bodens (4) enger werden lässt als im Bereich seiner Mündung, und wobei das Codierungssystem in diesen Absatz (9) eingegliedert ist.

## Claims

1. System comprising a base (1) and a module (3) slotting into said base (1) in order to electrically connect thereto for the transfer of information, the base being connected to an equipment item and the module (3) being connected to a management unit for managing said equipment item, **characterised in that** the base (1) is provided with an encoding system (16a-16f) for encoding a permanent-magnet magnetic address (17) comprising a plurality of encoding elements (16), each of which includes a slider (18) bearing a permanent magnet (17) and capable of moving in translation between a first encoding position (22) and a second encoding position (23), and **in that** the module (3) comprises means for reading the encoded address in the encoding system of the base (1), said reading means comprising a series of magnetic sensors, each of which is situated opposite a magnetic encoding element (16) when the module (3) is installed in the base (1), in addition to means for storing in memory the address read by the reading means provided that said module (3) is powered up and means for transmitting the address stored in memory to the management unit.

2. System according to claim 1, wherein each slider (18) comprises a lug (21), and wherein the base (1) is provided with a movable flap (24) that can be folded towards the encoding elements (16), said folding flap (24) comprising, for each encoding element (16), two openings (22, 23) for the passage of the lug (21) of the slider (18) of said encoding element (16), in order to allow the flap (24) to be folded back when each slider (18) is in its first position or its second position.

3. System according to claim 2, wherein the flap (24) is arranged such that it prevents the full engagement of the module (3) in the base, in addition to the connection thereof for as long as said movable flap (24) is not completely folded back against the encoding elements (16).

4. System according to one of the previous claims, wherein the module (3) engages inside a cavity (2) of the base (1) that is defined by at least one flank (7) comprising a step-shaped discontinuity (9) making the cavity (2) narrower at the bottom (4) thereof than at the aperture thereof, and wherein the encoding system is incorporated into said discontinuity (9).
